(19) Europäisches Patentamt
European Patent Office
Office européen des brevets

(11) **EP 4 116 771 A1**

(12) **EUROPEAN PATENT APPLICATION**

(43) Date of publication:
**11.01.2023  Bulletin 2023/02**

(51) International Patent Classification (IPC):
*G03F 7/20* (2006.01)

(21) Application number: **21184711.6**

(22) Date of filing: **09.07.2021**

(52) Cooperative Patent Classification (CPC):
**G03F 7/709; G03F 7/70858**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **VAN DE MEERENDONK, Remco**
**5500 AH Veldhoven (NL)**
• **KUSTERS, Roan**
**5500 AH Veldhoven (NL)**

• **WILBRINK, Mark, Wilhelmus, Ida, Maria**
**5500 AH Veldhoven (NL)**
• **BRUST, Steve, Gregory**
**5500 AH Veldhoven (NL)**
• **JANSSEN, Gerardus, Arnoldus, Hendricus, Franciscus**
**5500 AH Veldhoven (NL)**
• **WATERSON, Nicholas, Peter**
**5500 AH Veldhoven (NL)**
• **NAKIBOGLU, Günes**
**5500 AH Veldhoven (NL)**

(74) Representative: **ASML Netherlands B.V.**
**Corporate Intellectual Property**
**P.O. Box 324**
**5500 AH Veldhoven (NL)**

(54) **FLOW RESTRICTIVE ELEMENT AND USE THEREOF**

(57)   The present invention relates to a flow restrictive element comprising
an inlet part having a large cross-section entry and a small cross-section exit,
an outlet part having a small cross-section entry and a large cross-section exit, and
a spiral shaped tube having an inlet and an outlet, wherein the inlet is connected to the small cross-section exit of the inlet part and the outlet is connected to the small cross-section entry of the outlet part.

**FIG. 4**

**Description**

FIELD

The present invention relates to a flow restrictive element, the use of such flow restrictive element, a thermal conditioning system and a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

To control the temperature of critical parts of the lithographic apparatus, such as optical elements of the projection system, a thermal conditioning system using a conditional liquid may be applied. In an embodiment, such temperature conditioning system comprises one or more thermal conditioning conduits. The use of these thermal conditioning conduits provide effective cooling of the respective parts of the lithographic apparatus, the liquid flow may also cause vibrations within the respective part of the lithographic apparatus. These vibrations are herein referred to as flow induced vibrations (FIV).

To reduce the occurrence of flow induced vibrations in critical parts, it is desirable that the flow rate of conditioning liquid through the thermal conditioning liquid is relatively low. When a single liquid supply system is used to provide conditioning liquid for thermal conditioning of critical parts and other parts, a flow restrictive element may be used to create an additional pressure drop in a thermal conditioning conduit for a critical part in order to influence the distribution of liquid flow over multiple parallelly connected fluid conduit of a thermal conditioning system. This additional pressure drop allows to reduce the flow rate through the thermal conditioning conduit where the flow restrictive element is placed. This is often referred to as flow balancing.

With increasing requirements on the maximum level of flow induced vibrations that are allowed in critical parts of the lithographic apparatus, the presence of a flow restrictive element in the thermal conditioning conduit may be a dominant factor in the occurrence of flow induced vibrations for critical parts of the lithographic apparatus.

SUMMARY

The object of the invention is to provide a flow restrictive element that can be used to provide a relatively large pressure drop in combination with the creation of relatively low flow induced vibrations.

An first inventive aspect of the invention provides a flow restrictive element for reducing flow induced vibrations in a flow which passes through the flow restrictive element, comprising: an inlet part having a large cross-section entry and a small cross-section exit, an outlet part having a small cross-section entry and a large cross-section exit, and a spiral shaped tube having an inlet and an outlet, wherein the inlet is connected to the small cross-section exit of the inlet part and the outlet is connected to the small cross-section entry of the outlet part.

A second inventive aspect of the invention provides a use of the flow restrictive element of any of the embodiments of the first aspect of the invention within a lithography apparatus to provide a flow restriction in a liquid conduit to provide a relatively high pressure drop in combination with relatively low flow induced vibrations.

A third inventive aspect of the invention provides a thermal conditioning system for a lithography apparatus, the thermal conditioning system comprising: multiple thermal conditioning conduits to guide conditioning liquid, and a liquid supply system to supply conditioning liquid to the multiple thermal conditioning conduits, wherein at least one of the thermal conditioning conduits comprises the flow restrictive element of any of the embodiments of the first inventive aspect to create a relatively high pressure drop in combination with relatively low flow induced vibrations.

A fourth inventive aspect of the invention provides a lithographic apparatus comprising the thermal conditioning system of the third inventive aspect.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 depicts a liquid supply system according to an embodiment of the invention;
- Figure 3 depicts a prior art flow restrictive element;
- Figure 4 depicts a first embodiment of a flow restrictive element according to the invention;
- Figure 5 depicts a second embodiment of a flow restrictive element according to the invention;
- Figure 6 depicts a third embodiment of a flow restrictive element according to the invention; and

- Figure 7 depicts a fourth embodiment of a flow restrictive element according to the invention.

DETAILED DESCRIPTION

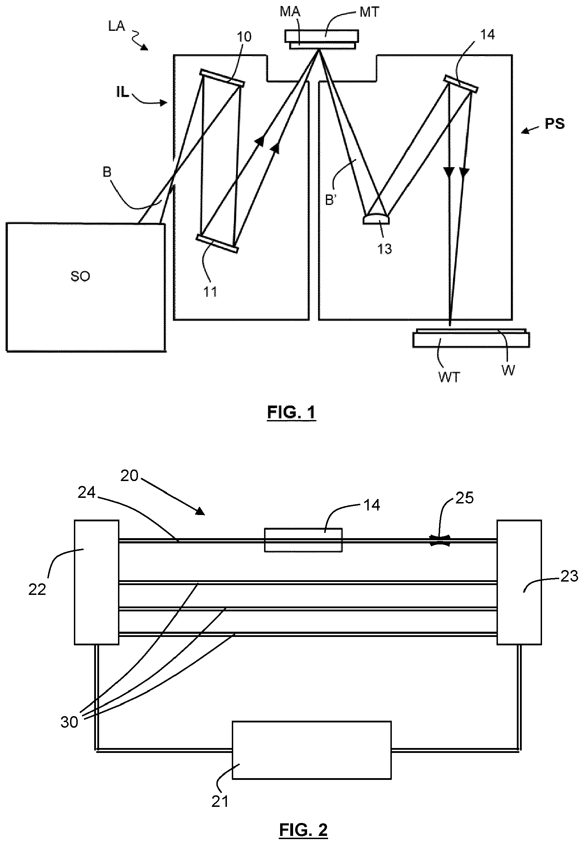

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Although in figure 1 is described an EUV lithography system, this invention may be also applied to other types of lithography apparatus, such as DUV lithography systems, or metrology inspection systems in the field of lithography.

Figure 2 depicts schematically a thermal conditioning system for a lithographic apparatus generally denoted by reference numeral 20. The thermal conditioning system 20 comprises a liquid supply system having a conditioning liquid pumping system 21, a supply manifold 22 and a return manifold 23. The supply manifold 22 and the return manifold 23 are connected to a number of thermal conditioning conduits 24, 30 that are parallelly connected to the supply manifold 22 and the return manifold 23. The liquid pumping system 21 is arranged to pump liquid through the thermal conditioning conduits 24, 30. The liquid pumping system 21 also comprises a conditioning device to maintain the temperature of the conditioning liquid at a desired temperature level. The supply manifold 22 is constructed to distribute the conditioning liquid over the thermal conditioning conduits 24, 30.

In some of the thermal conditioning conduits 24, 30, it may be desirable that the flow rate through the thermal conditioning conduits 24, 30, is relatively low in order to reduce flow induced disturbances caused by a flow rate of the liquid passing through the thermal conditioning conduits 24, 30. The flow rate may be in the range of 0.1 to 15 L/min for example 0.15 to 1.25 L/min during an exposure phase of a lithographic apparatus. This reduced flow rate is, for example, desirable for the upper thermal conditioning conduit 24 of Figure 2 which is used for thermal conditioning of the mirror element 14. To reduce the flow rate of the liquid flow through this thermal conditioning conduit 24, a flow restrictive element 25 is arranged in this thermal conditioning conduit 24. In the shown embodiment, the flow restrictive element 25 is arranged between the mirror element 14 and the return manifold 23. In addition, or as an alternative, a similar flow restrictive element could be placed between the supply manifold 22 and the mirror element 14, or at any other suitable location.

This flow restrictive element 25 introduces an additional pressure drop in the thermal conditioning conduit 24 that causes a reduced liquid flow rate through the thermal conditioning conduit 24.. More generally, the flow rate for thermal conditioning conduits used for conditioning of parts that are sensitive for flow induced vibrations can be lowered by introducing a flow restrictive element in the respective thermal conditioning conduit.

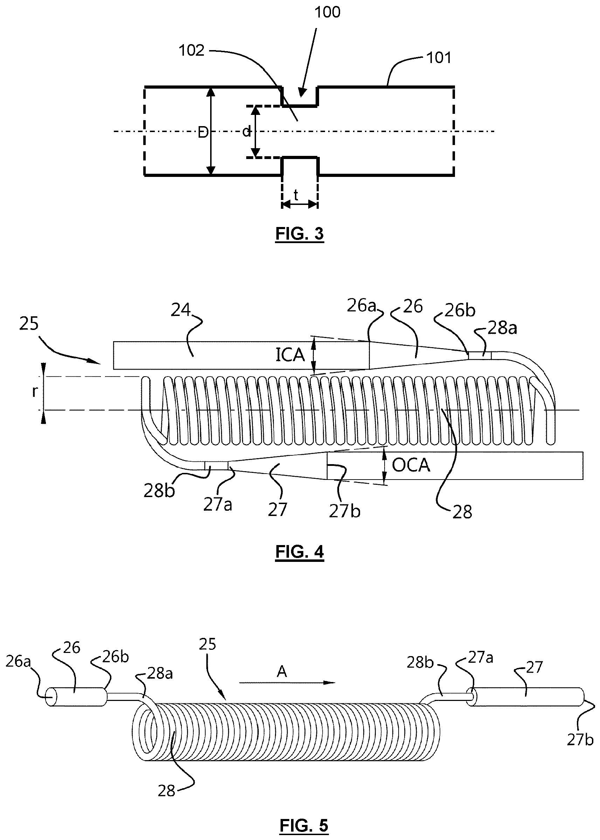

Figure 3 depicts an embodiment of a flow restrictive element 100 known from prior art which is used to create a pressure drop in a liquid conduit 101. The flow restrictive element 100 is formed as an orifice 102 in the liquid conduit 101. The orifice 102 has an inner diameter d and a length t. The liquid conduit 101 has an inner diameter D, wherein d is substantially smaller than D. The flow restrictive element 100 is for example formed by a hole provided in a plate element. In this flow restrictive element 100, the pressure drop depends primarily on the ratio d/D and to a lesser extent on d/t. Due to the desired combination of a low flow rate through the liquid conduit 101 and a high pressure drop, the diameter d of the orifice 102 may become very small, which makes it more sensitive for manufacturing tolerances and cavitation.

Further, in this type of flow restrictive element, the pressure drop is associated with turbulent separated flow caused by the orifice 102 in the thermal conditioning conduit 101. This turbulence separated flow will typically cause relatively high flow induced vibrations. With increasing requirements on the maximum level of flow induced vibrations that can be accepted in the thermal conditioning conduit 101, the flow restrictive element 100 of the type showed in Figure 3 in which pressure drop is based on turbulence separated flow does no longer fulfil these requirements. As a consequence, acoustic pressure waves resulting from flow induced vibrations will be transmitted to an element to be conditioned by thermal conditioning system 20. If the element is an optical element in a lithography apparatus or a metrology system, for example an EUV mirror or a DUV lens, or mirror or a lens in a metrology system, the vibration in said optical element will distort the radiation beam to be transmitted to the substrate affecting to the resolution and performance of the lithography apparatus or the metrology system.

Figure 4 depicts a first embodiment of a flow restrictive element 25 according to the invention. The flow restrictive element 25 comprises a inlet part 26, a outlet part 27 and a spiral shaped tube 28. The inlet part 26 comprises a large cross-section entry 26a and a small cross-section exit 26b. This means that the large cross-section entry 26a has a first inlet cross section and the small cross-section exit 26b has a first outlet cross section, wherein the first inlet cross section is larger than the first outlet cross section. The outlet part 27 comprises a small cross-section entry 27a and a large cross-section exit 27b. This means that the small cross-section entry 27a has a second inlet cross section and the large cross-section exit 27b has a second outlet cross section, wherein the second inlet cross section is smaller than the second outlet cross section.

In the embodiment of Figure 4, the inner surfaces of the inlet part 26 and the outlet part 27 are conical surfaces running from the large cross-section entry 26a to the small cross-section exit 26b and form the small cross-section entry 27a to the large cross-section exit 27b, respectively.

The spiral shaped tube 28 comprises an inlet 28a and an outlet 28b. The inlet 28a is connected to the small cross-section exit 26b of the inlet part 26 and the outlet 28b is connected to the small cross-section entry 27a of the outlet part 27. Spiral shaped tube 28 means that a main part of the tube between the inlet 28a and the outlet 28b is shaped in the form of a helix.

The spiral shaped tube 28 has a relatively long length compared to the inner diameter of the spiral shaped tube 28. As a result, the pressure drop created by the flow restrictive element 25 is created due to viscous losses by means of shear stress. This is also referred to as skin friction. The high viscous losses are obtained by generating high velocity gradients at the inner wall of the spiral shaped tube 28 in a turbulent flow regime. These high velocity gradients are obtained by the relatively small inner diameter of the spiral shaped tube 28 compared with its length. This results in the generation of high wall shear stresses, i.e. $\tau_w = \tau(y = 0) = \mu \, \partial u / \partial y$ at $y = 0$, where u is the axial flow velocity, y is the distance normal to the wall and $\mu$ is the dynamic viscosity of the fluid. By using a relatively long tube length, as provided by the spiral shaped tube 28, the surface area over which the wall shear stresses act is relatively large which results in an a relatively pressure drop.

The use of this skin friction to create pressure drop substantially decreases the occurrence of flow induced vibrations when compared to embodiments of flow restrictive elements that create a pressure drop based on turbulent separated flow. The inlet part 26 and the outlet part 27 are constructed to provide a gradual transition from the inner diameter of the thermal conditioning conduit 24 to the inlet 28a of the spiral shaped tube 28 and from the outlet 28b of the spiral shaped tube 28 to the inner diameter of the thermal conditioning conduit 24, respectively. Such gradual transition prevents the occurrence of separated flow effects and further reduces the occurrence of flow induced vibrations in the thermal conditioning conduit 24.

The spiral shape of the spiral shaped tube 28 is provided in order to accommodate a long tube length within a relatively small space. To prevent that the spiral curvature radius of the spiral shape substantially contributes to the generation of flow induced vibrations, the spiral curvature radius should not be made to small. The ratio between the spiral curvature radius and the inner diameter of the spiral shaped tube 28 should for example be at least 5, i.e. the ratio $r/\text{ID} > 5$, wherein r is the spiral curvature radius and ID is the inner diameter of the spiral shaped tube 28.

The spiral shaped tube may comprise a spiral tube length TL of 0.25 to 10 m, for example 1 - 5 m and an inner diameter ID of 0.5 - 10 mm, for example 1 - 5 mm. The ratio between the spiral tube length TL and the inner diameter ID is at least 25, i.e. $\text{TL}/\text{ID} > 25$. In an embodiment the ratio $\text{TL}/\text{ID}$ may be at least 50, for instance at least 100. As an example, the ratio $\text{TL}/\text{ID}$ may be in the range of 500 - 5000.

The inlet part 26 comprises an inlet cone angle ICA and an inlet cross-section ratio ICR between a cross-section of the large cross-section entry 26a and a cross-section of the small cross-section exit 26b. To provide a gradual transition between the large cross-section entry 26a and a cross-section of the small cross-section exit 26b:

- when the inlet cross-section area ratio ICR is equal to or smaller than three, the inlet cone angle ICA is equal to or smaller than 60 degrees, and
- when the inlet cross-section area ratio ICR is larger than three, the inlet cone angle ICA is equal to or smaller than 30 degrees.

The inlet cone angle ICA is provided as a constant angle over the complete length of the inlet part 26 the large cross-section entry 26a to the small cross-section exit 26b.

The outlet part 27 comprises an outlet cone angle OCA and an outlet cross-section ratio OCR between the cross section of large cross-section exit 27b and the small cross-section entry 27a, and wherein:

- when the outlet cross-section area ratio OCR is equal to or smaller than three, the outlet cone angle OCA is equal to or smaller than 7 degrees,
- when the outlet cross-section area ratio OCR is larger than three and equal to or smaller than eight, the outlet cone angle OCA is equal to or smaller than 5 degrees, and
- when the outlet cross-section area ratio is larger than eight, the outlet cone angle starting from the small cross-section entry is equal to about 5 degrees up to an area ratio OCR of eight, followed by a sudden step to the diameter of the large cross-section exit.

The inlet cone angle ICA and the outlet cone angle OCA are shown in Figure 4. It is noted that the inlet cone angle ICA and the outlet cone angle OCA relate to the angle of the inner wall of the inlet part 26 and the outlet part 27, respectively.

When the flow restrictive element 25 is designed as discussed above, the flow rate through the flow restrictive element may for example be 0.1 to 15 L/min, for example 0.15 to 1.25 L/min" such as about 0.5 liters per minute without creating substantial flow induced vibrations. The pressure drop provided by the flow restrictive element 25, is at least 0.1 bar, for example at least 1.5 bar. The pressure drop of the flow restrictive element 25 can be tuned by adjusting a spiral tube length TL, inner diameter ID of the tube and/or spiral bending radius r.

In addition to preventing the generation of flow induced vibrations, the spiral shaped tube 28 of the flow restrictive element 25 of the invention may also facilitate damping of flow induced vibrations. The hydraulic damping of the spiral shaped tube 28 may be estimated as R = d$\Delta$P/dq, wherein the pressure difference $\Delta$P is proportional to the volume flow rate $q\left[\frac{m^3}{s}\right]$ of liquid through the conditioning liquid 24. The high shear stress an associated high pressure drop created by the spiral shaped tube 28 create significant damping, which also dampens the incoming acoustic pressure fluctuations, for instance caused by a system to pump the liquid through the thermal conditioning conduit 24.

Figure 5 depicts a second embodiment of a flow restrictive element 25 according to the invention. In this second embodiment, the inlet part 26, the spiral shaped tube 28 and the outlet part 27 are arranged in an aligned configuration in one flow direction, i.e. the flow through the flow restrictive element 25 comprises substantially continuously a positive vector component in a single direction, indicated by arrow A.

The inlet part 26 has an inlet cone angle ICA and the outlet part 27 has an outlet cone angle OCA at the inner wall of the conduit running through the flow restrictive element 25. The outer walls of the inlet part 26 and the outlet part 27 are cylindrical. The angles of the inlet cone angle ICA and the outlet cone angle OCA can be constructed the same as described with respect to the embodiment of Figure 4.

Also, the other characteristics of the flow restrictive element, such as spiral tube length TL, inner diameter ID of the tube and/or spiral bending radius r may be constructed the same as described with respect to the embodiment of Figure 4.

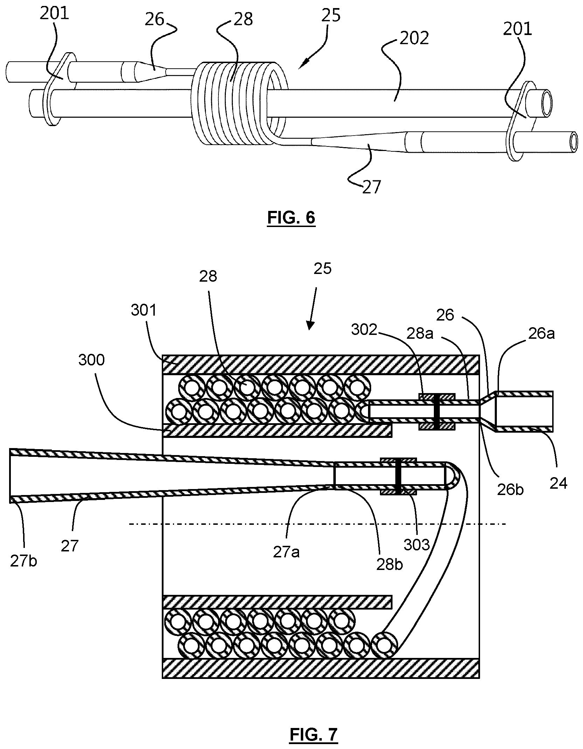

Figure 6 depicts a third embodiment of a flow restrictive element 25 according to the invention. The flow restrictive element 25 having inlet part 26, outlet part 27 and spiral shaped tube 28 is mounted on a pipe element 200 using two mounting brackets 201. The mounting brackets 201 constrain the flow restrictive element 25 in the desired shape.

Figure 7 depicts a fourth embodiment of a flow restrictive element 25 according to the invention. The flow restrictive element 25 comprises an inlet part 26, an outlet part 27 and a spiral shaped tube 28. The construction and advantages of the flow restrictive element 25 generally correspond to the construction and advantages described with respect to the embodiment of Figure 4. In this embodiment, the spiral shaped tube 28 is created by winding a flexible tube on a cylinder 300. The flexible tube can be cut with a cutting device such as a knife. The use of the flexible tube has the advantage that the it is relatively easy to tune the pressure drop by cutting the flexible tube to a desired length. The flexible tube is protected by an outer cylinder 301. The flexible tube can be releasably connected to the inlet part 26 and the outlet part 27 at a first connector 302 and a second connector 303, respectively.

The embodiment of figure 7 is configured to generate a pressure drop by viscous effects and avoids turbulence, hence significantly reducing the FIV compared to a conventional restricting orifices / needle valves. As in the previous embodiments, the embodiment of figure 7 may comprise a conical contraction, flexible spiral shaped tube and conical expansion. The conical contraction and expansions may be understood as the conical surfaces as defined in the embodiment of figure 4.

The conical contraction minimizes FIV, because the flow is gradually contracted, i.e. the flows goes from a large flow field surface area to a small flow field surface area. The spiral shaped tube is configured to drop the pressure due to the viscous friction effects to the wall of the spiral shaped tube which is in turn achieved by the velocity gradient near the wall of the tube.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.

1. A flow restrictive element for reducing flow induced vibrations in a flow which passes through the flow restrictive element, comprising: an inlet part having a large cross-section entry and a small cross-section exit, an outlet part having a small cross-section entry and a large cross-section exit, and a spiral shaped tube having an inlet and an outlet, wherein the inlet is connected to the small cross-section exit of the inlet part and the outlet is connected to the small cross-section entry of the outlet part.

2. The flow restrictive element of clause 1, wherein the spiral shaped tube comprises a spiral curvature radius and an inner diameter wherein the ratio between the curvature radius and the inner diameter is larger than five.

3. The flow restrictive element of clause 1 or 2, wherein the inlet part comprises an inlet cone angle and an inlet cross-section ratio between the large cross-section entry and the small cross-section exit, and wherein: when the inlet cross-section area ratio is equal to or smaller than three, the inlet cone angle is equal to or smaller than 60 degrees, and when the inlet cross-section area ratio is larger than three, the inlet cone angle is equal to or smaller than 30 degrees.

4. The flow restrictive element of any of the preceding clauses, wherein the outlet part comprises an outlet cone angle and an outlet cross-section ratio between the large cross-section exit and the small cross-section entry, and wherein: when the outlet cross-section area ratio is equal to or smaller than three, the outlet cone angle is equal to or smaller than 7 degrees, when the outlet cross-section area ratio is larger than three and equal to or smaller than eight, the outlet cone angle is equal to or smaller than 5 degrees, and when the outlet cross-section area ratio is larger than eight, the outlet cone angle starting from the small cross-section entry is equal to about 5 degrees up to an outlet cross-section area ratio of eight, followed by a sudden step to the diameter of the large cross-section exit.

5. The flow restrictive element of any of the preceding clauses, wherein the spiral shaped tube comprises a spiral tube length of 0.25 to 10 m and an inner diameter of 0.5 - 10 mm

6. The flow restrictive element of clause 5, wherein a ratio between the spiral tube length and the inner diameter is at least 25.

7. The flow restrictive element of any of the preceding clauses, wherein the flow rate through the flow-restrictive element is 0.5 to 4 liters per minute.

8. The flow restrictive element of any of the preceding clauses, wherein the inlet part, the spiral shaped tube and the outlet part are arranged in an aligned configuration in which the flow direction through the flow restrictive element has substantially continuously a positive vector component in a one direction.

9. The flow restrictive element of any of the preceding clauses, wherein the flow restrictive element is constructed to generate a pressure drop by viscous losses by means of shear stresses.

10. Use of a flow restrictive element of any of the preceding clauses to provide a flow restriction in a liquid conduit to provide a relatively high pressure drop in combination with relatively low flow induced vibrations in the liquid conduit.

11. The use of clause 10, wherein the flow restrictive element is arranged to dampen flow induced vibrations in the liquid flow flowing through the liquid conduit.

12. The use of clause 10 or 11, wherein the flow restrictive element is applied in a thermal conditioning conduit of a temperature conditioning system.

13. The use of any of the clauses 10-12, comprising the step of tuning the pressure drop of the flow-restrictive element by selecting a spiral tube length, inner diameter and/or spiral curvature radius of the spiral shaped tube.

14. The use of any of the clauses 10-13, wherein the pressure drop created by the flow-restrictive element is at least 0.1 bar.

15. A thermal conditioning system comprising: one or more thermal conditioning conduits to guide conditioning liquid, and a liquid supply system to supply conditioning liquid to the one or more thermal conditioning conduits, wherein at least one of the one or more thermal conditioning conduits comprises the flow restrictive element of any of the clauses 1-9 to create a relatively high pressure drop in combination with relatively low flow induced vibrations.

16. The thermal conditioning system of clause 15, wherein the liquid supply system is arranged to provide a flow rate through the flow-restrictive element in a range of 0.1 to 15 liters per minute.

17. A lithographic apparatus comprising the thermal conditioning system of clause 15 to thermally condition an object of the lithographic apparatus.

18. The lithographic apparatus of clause 17, wherein the object is an element of a projection system of the lithographic apparatus.


**Claims**

1. A flow restrictive element for reducing flow induced vibrations in a flow which passes through the flow restrictive element, comprising:

    an inlet part having a large cross-section entry and a small cross-section exit,
    an outlet part having a small cross-section entry and a large cross-section exit, and
    a spiral shaped tube having an inlet and an outlet, wherein the inlet is connected to the small cross-section exit of the inlet part and the outlet is connected to the small cross-section entry of the outlet part.

2. The flow restrictive element of claim 1, wherein the spiral shaped tube comprises a spiral curvature radius and an inner diameter wherein the ratio between the curvature radius and the inner diameter is larger than five.

3. The flow restrictive element of claim 1 or 2, wherein the inlet part comprises an inlet cone angle and an inlet cross-section ratio between the large cross-section entry and the small cross-section exit, and wherein:

    when the inlet cross-section area ratio is equal to or smaller than three, the inlet cone angle is equal to or smaller than 60 degrees, and
when the inlet cross-section area ratio is larger than three, the inlet cone angle is equal to or smaller than 30 degrees.

4. The flow restrictive element of any of the preceding claims, wherein the outlet part comprises an outlet cone angle and an outlet cross-section ratio between the large cross-section exit and the small cross-section entry, and wherein:

    when the outlet cross-section area ratio is equal to or smaller than three, the outlet cone angle is equal to or smaller than 7 degrees,
    when the outlet cross-section area ratio is larger than three and equal to or smaller than eight, the outlet cone angle is equal to or smaller than 5 degrees, and
    when the outlet cross-section area ratio is larger than eight, the outlet cone angle starting from the small cross-section entry is equal to about 5 degrees up to an outlet cross-section area ratio of eight, followed by a sudden step to the diameter of the large cross-section exit.

5. The flow restrictive element of any of the preceding claims, wherein the spiral shaped tube comprises a spiral tube length of 0.25 to 10 m and an inner diameter of 0.5 - 10 mm

6. The flow restrictive element of claim 5, wherein a ratio between the spiral tube length and the inner diameter is at least 25.

7. The flow restrictive element of any of the preceding claims, wherein the flow rate through the flow-restrictive element is 0.5 to 4 liters per minute.

8. The flow restrictive element of any of the preceding claims, wherein the inlet part, the spiral shaped tube and the outlet part are arranged in an aligned configuration in which the flow direction through the flow restrictive element has substantially continuously a positive vector component in a one direction.

9. The flow restrictive element of any of the preceding claims, wherein the flow restrictive element is constructed to generate a pressure drop by viscous losses by means of shear stresses.

10. Use of a flow restrictive element of any of the preceding claims within a lithography apparatus to provide a flow restriction in a liquid conduit to provide a relatively high pressure drop in combination with relatively low flow induced vibrations in the liquid conduit, wherein the flow restrictive element is arranged to dampen flow induced vibrations in the liquid flow flowing through the liquid conduit,
the use comprises the step of tuning the pressure drop of the flow-restrictive element by selecting a spiral tube length, inner diameter and/or spiral curvature radius of the spiral shaped tube.

11. The use of claim 10, wherein the pressure drop created by the flow-restrictive element is at least 0.1 bar.

12. A thermal conditioning system for a lithography apparatus comprising:

   one or more thermal conditioning conduits to guide conditioning liquid, and
   a liquid supply system to supply conditioning liquid to the one or more thermal conditioning conduits,

   wherein at least one of the one or more thermal conditioning conduits comprises the flow restrictive element of any of the claims 1-9 to create a relatively high pressure drop in combination with relatively low flow induced vibrations.

13. The thermal conditioning system of claim 12, wherein the liquid supply system is arranged to provide a flow rate through the flow-restrictive element in a range of 0.1 to 15 liters per minute.

14. A lithographic apparatus comprising the thermal conditioning system of claim 12 or 13 to thermally condition an object of the lithographic apparatus.

15. The lithographic apparatus of claim 14, wherein the object is an element of a projection system of the lithographic apparatus.

FIG. 1

FIG. 2

FIG. 3

FIG. 4

FIG. 5

**FIG. 6**

**FIG. 7**

Europäisches
Patentamt

European
Patent Office

Office européen
des brevets

## EUROPEAN SEARCH REPORT

Application Number

EP 21 18 4711

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 856 588 A (QINGDAO HAIER AIR CONDITIONER ET AL.) 28 May 2021 (2021-05-28) | 1-9, 11-13 | INV. G03F7/20 |
| Y | * paragraph [0051] – paragraph [0110] * * figures 1-5,12-14 * | 10,14,15 | |
| Y | WO 03/092057 A1 (NIPPON KOGAKU KK [JP]; SENDAI NIKON CORP [JP] ET AL.) 6 November 2003 (2003-11-06) | 10,14,15 | |
| A | * paragraph [0031] – paragraph [0102] * * figures 1,4 * | 1 | |

TECHNICAL FIELDS
SEARCHED (IPC)

G03F

The present search report has been drawn up for all claims

| Place of search | Date of completion of the search | Examiner |
|---|---|---|
| Munich | 13 December 2021 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 21 18 4711**

This annex lists the patent family members relating to the patent documents cited in the above-mentioned European search report.
The members are as contained in the European Patent Office EDP file on
The European Patent Office is in no way liable for these particulars which are merely given for the purpose of information.

**13-12-2021**

| Patent document cited in search report | | Publication date | Patent family member(s) | | Publication date |
|---|---|---|---|---|---|
| CN 112856588 | A | 28-05-2021 | NONE | | |
| WO 03092057 | A1 | 06-11-2003 | AU | 2003235124 A1 | 10-11-2003 |
| | | | JP | 4205054 B2 | 07-01-2009 |
| | | | JP | WO2003092057 A1 | 02-09-2005 |
| | | | TW | I284785 B | 01-08-2007 |
| | | | US | 2005140946 A1 | 30-06-2005 |
| | | | WO | 03092057 A1 | 06-11-2003 |

EPO FORM P0459

For more details about this annex : see Official Journal of the European Patent Office, No. 12/82